# EUROPÄISCHE PATENTSCHRIFT

(11) **EP 3 502 429 B1**
(45) Veröffentlichungstag und Bekanntmachung des Hinweises auf die Patenterteilung: **15.07.2020**
(21) Anmeldenummer: 17209969.9
(22) Anmeldetag: 22.12.2017
(51) Int. Cl.: F01N 3/04, F01N 5/02, F01N 13/08, F01N 13/10, F01N 13/14, F01N 13/18, F28D 1/00, H01L 35/30

(54) **ABGASKRÜMMER MIT THERMOELEKTRISCHEM ELEMENT**
EXHAUST MANIFOLD WITH THERMOELECTRIC ELEMENT
COLLECTEUR DE GAZ D'ÉCHAPPEMENT AVEC ÉLÉMENT THERMOÉLECTRIQUE

(43) Veröffentlichungstag der Anmeldung: 26.06.2019
(73) Patentinhaber: GF Casting Solutions AG, 8200 Schaffhausen (CH)
(72) Erfinder: PAPADIMITRIOU, Ilias, 8200 Schaffhausen (DE); GRAF, Christian, 78345 Iznang (DE)
(74) Vertreter: Fenner, Seraina

(56) Entgegenhaltungen:
- EP-A1- 2 180 534
- EP-A1- 2 489 846
- WO-A1-2011/045659
- DE-A1-102015 205 898

## Beschreibung

Die Erfindung betrifft einen Abgaskrümmer mit thermoelektrischem Element zur Nutzung der Abwärme des Verbrennungsmotors beinhaltend einen Abgaskrümmer vorzugsweise aus Gussmaterial, mindestens ein thermoelektrisches Element, wobei das thermoelektrische Element vorzugsweise als Platte ausgebildet ist und das thermoelektrische Element durch die auftretende Temperaturdifferenz zwischen der einen Seite und der gegenüberliegenden Seite eine elektrische Spannung erzeugt, wobei mindestens ein thermoelektrisches Element an mindestens einer Abgaskrümmerseite angeordnet ist.

Zur Steigerung der Leistung bzw. der Wirtschaftlichkeit eines Fahrzeugs ist es bekannt thermoelektrische Elemente einzusetzen, die die Abwärme des Verbrennungsmotors nutzen um zusätzliche Energie zu generieren. Aus dem Stand der Technik werden solche Elemente meist im Bereich der Auspuffanlage eingesetzt. Solche thermoelektrischen Elemente machen ökonomisch aber erst dann Sinn wenn eine hohe Temperaturdifferenz zwischen der einen Seite des Elements und der anderen Seite des Elements vorliegen da dadurch eine Spannung generiert wird. Nachteilig an thermoelektrischen Elementen die im Auspuffbereich befestigt sind ist, dass eine zu geringe Temperaturdifferenz vorliegt um eine solche Energiegewinnung zu erzielen, dass es wirtschaftlich sinnvoll ist.

Die US 2016/012592 A1 offenbart einen Generator für einen Verbrennungsmotor, wobei mehrere thermoelektrische Module an einem Wärmeschutz angeordnet sind der den Abgaskrümmer bedeckt.

Nachteilig hierbei ist, dass die thermoelektrischen Module nicht direkt von der maximalen Temperatur, die im Abgaskrümmer herrscht, beaufschlagt werden, sondern durch den Wärmeschutz auf dem sie befestigt sind, von der Abwärme des Verbrennungsmotors isoliert werden und dadurch keine maximale Temperaturdifferenz im thermoelektrischen Element zwischen der dem Motor zugewandten und der dem Kühlelement anliegenden Seite erreicht wird. Die EP 2 489 846 A1 offenbart einen Abgaskrümmer mit einem thermoelektrischen Element und einem Kühlelement, wobei der Abgaskrümmer und das Kühlelement separate Teil sind. Das Kühlelement ist als Blechteil ausgeführt.

Die WO 2011/045659 A1 zeigt einen Abgaskrümmer mit einem thermoelektrischen Element und einem Kühlelement, wobei das Kühlelement als Gussteil ausgeführt ist. Der Abgaskrümmer und das Kühlelement sind als ein gesamtheitliches Bauteil ausgeführt.

Es ist Aufgabe der Erfindung einen Abgaskrümmer mit einem thermoelektrischen Element zur Nutzung der Abwärme des Verbrennungsmotors vorzuschlagen bei dem eine hohe Energiegewinnung mittels der Abhitze des Verbrennungsmotors generiert werden kann und dadurch ein wirtschaftlicher Vorteil erzielt wird.

Diese Aufgabe wird erfindungsgemäss dadurch gelöst, dass am thermoelektrischen Element an der vom Abgaskrümmer abgewandten Seite ein Kühlelement angeordnet ist, wobei das Kühlelement mindestens einen Kühlkanal aufweist, wobei der Kühlkanal zur Durchströmung eins Fluids dient.

Die vorliegende Erfindung befasst sich mit einem Abgaskrümmer mit mindestens einem thermoelektrischen Element zur Nutzung der Abwärme des Verbrennungsmotors. Der erfindungsgemässe Abgaskrümmer mit thermoelektrischem Element beinhaltet einen Abgaskrümmer vorzugsweise bestehend aus Gussmaterial, speziell bevorzugt aus Stahl- oder Eisengusss, wobei auch ein Abgaskrümmer aus Blech oder andern Materialeren vorstellbar ist, mindestens ein thermoelektrisches Element, wobei das thermoelektrische Element vorzugsweise als Platte ausgebildet ist und das thermoelektrische Element durch die auftretende Temperaturdifferenz zwischen der einen Seite der Platte und der gegenüberliegenden Seite der Platte eine elektrische Spannung erzeugt, wobei das thermoelektrische Element auch andere Bauformen wie Platten aufweisen kann. Mindestens ein thermoelektrisches Element ist an der Abgaskrümmerseite angeordnet, wobei unter Abgaskrümmerseite die Aussenseiten wie Oberseite und Unterseite des Abgaskrümmers zu verstehen ist wie auch die Frontseite, die die Ober- und Unterseite verbindet und vorzugsweise als Radius ausgebildet ist.

An jedem thermoelektrischen Element an der vom Abgaskrümmer abgewandten Seite ist ein Kühlelement angeordnet, wobei das Kühlelement mindestens einen Kühlkanal aufweist, wobei der Kühlkanal zur Durchströmung eines Fluids dient. Durch das Anbringen von Kühlelementen an den thermoelektrischen Elementen an derer vom Abgaskrümmer abgewandten Seiten wird eine sehr hohe Temperaturdifferenz erzielt, die zur Erzeugung einer hohen Spannung dient.

Erfindungsgemäß sind der Abgaskrümmer und das Kühlelement als separate Teile ausgeführt. Dies ermöglicht auch die separate Herstellung des Abgaskrümmers und des Kühlelements sowie dass unterschiedliche Materialien verwendet werden können, die spezifisch auf die Anforderungen angepasst sind. Dadurch, dass die Teile nicht miteinander verbunden bzw. nicht als ein Teil ausgebildet sind, kann vermieden werden, dass eine Wärmebrücke entsteht bei der die Wärme des Abgaskrümmers auf das Kühlelement übergeht.

Vorzugsweise erstreckt sich ein Kühlelement über die komplette Breite einer Abgaskrümmerseite, das heisst vorzugsweise über die komplette Breite der Abgaskrümmeroberseite und/oder der Abgaskrümmerunterseite und/oder der Abgaskrümmerfrontseite, worunter zu verstehen ist, dass sich das Kühlelement über alle Abgaseinlässe erstreckt.

Vorzugsweise erstreckt sich ein Kühlelement auch über die komplette Länge einer Abgaskrümmerseite, vorzugsweise der Abgaskrümmeroberseite und/oder der Abgaskrümmerunterseite, das heisst, entlang der Abgaseinlässe bis hin zum Auslassstutzen bei dem die Abgaseinlässe zusammengeführt sind. Dies bringt eine optimale Ausnutzung der zur Verfügung stehenden Fläche des Abgaskrümmers. Das oder die Kühlelemente sind vorzugsweise über die komplette Breite und Länge als einteiliges, durchgehendes Element ausgebildet. Dadurch können unnötige Trennstellen, die keine optimale Flächenausnutzung zur Folge haben vermieden werden wie auch die Befestigung am Abgaskrümmer einfacher ausfällt.

Als weitere bevorzugte Ausführungsform ist an der Frontseite, welche die Abgaskrümmerober- und Unterseite verbindet und vorzugsweise als Radius ausgestaltet ist, ebenfalls ein thermoelektrisches Element angeordnet bei dem ebenfalls an der vom Abgaskrümmer abgewandten Seite ein Kühlelement anliegt. Wodurch die Oberfläche des Abgaskrümmers optimal genutzt wird.

Das Kühlelement ist erfindungsgemäß als Gussteil ausgebildet, wobei das Kühlelement speziell bevorzugt als Aluminium oder Magnesium Druckgussteil ausgebildet ist.

Als mögliche weitere Ausführungsform kann das Kühlelement auch als Frästeil oder Blechteil ausgebildet sein, wobei es dann durch zwei Halbschalen gebildet ist um den Kühlkanal einzubringen, die dann zu einem Kühlelement zusammengebaut werden, welches vorzugsweise eine Dichtung enthält um die Halbschalen zueinander abzudichten.

Vorteilhaft ist es, wenn das Kühlelement an einer Seite direkt am thermoelektrischen Element anliegt bzw. die Oberflächen des Kühlelements sich mit der Oberfläche des thermoelektrischen Elements kontaktieren ohne dass ein weiteres Element oder Material dazwischen angeordnet ist. Dadurch wird das thermoelektrische Element auf der Seite des Kühlelements optimal gekühlt und erfährt dadurch eine hohe Temperaturdifferenz zwischen den beiden Seiten des thermoelektrischen Elements.

Um wie oben erwähnt eine möglichst hohe Temperaturdifferenz zwischen den beiden Seiten des thermoelektrischen Elements zu erzielen, liegt mindestens ein thermoelektrisches Element bzw. eine Seite davon direkt an einer Abgaskrümmerseite an. Vorzugsweise liegt ein thermoelektrisches Element mit dessen Seite direkt an der äusseren Oberfläche der Abgaskrümmerunterseite und/oder der Abgaskrümmeroberseite und/oder der Abgaskrümmerfrontseite an bzw. es ist ausschliesslich ein vorzugsweise durchgehendes thermoelektrisches Element an der jeweiliger Seite angeordnet, dies gewährleistet eine optimale Ausnutzung der wärmenden Fläche des Abgaskrümmers.

Als alternative Ausführungsform ist ein Füllelement zwischen der äusseren Oberfläche der Abgaskrümmerseite und dem thermoelektrischen Element angeordnet. Vorzugsweise ist das Füllelement zwischen der Oberfläche der Abgaskrümmerunterseite und/oder der äusseren Oberfläche der Abgaskrümmeroberseite und dem thermoelektrischen Element angeordnet. Das Füllelement ist aus einem gut leitenden Material hergestellt, dass die Wärme des Abgaskrümmers möglichst ohne Verluste an das thermoelektrische Element weiterleitet. Es dient hauptsächlich zur einfacheren Befestigung des thermoelektrischen Elements bzw. des Kühlelementes am Abgaskrümmer.

Als eine bevorzugte Ausgestaltung hat sich gezeigt, dass das thermoelektrische Element am Kühlelement befestigt ist, vorzugsweise mittels eines Befestigungsmittels. Dadurch kann eine vormontierte Baugruppe gebildet werden die einfach am Abgaskrümmer befestigt werden kann.

Ausführungsbeispiele der Erfindung werden anhand der Figuren beschrieben, wobei sich die Erfindung nicht nur auf diese Ausführungsbeispiele beschränkt. Es zeigen:
- Fig. 1: eine dreidimensionale Darstellung eines erfindungsgemässen Abgaskrümmers mit thermoelektrischen Elementen,
- Fig. 2: eine Draufsicht eines erfindungsgemässen Abgaskrümmers mit thermoelektrischen Elementen,
- Fig. 3: eine Seitenansicht eines erfindungsgemässen Abgaskrümmers mit thermoelektrischen Elementen,
- Fig. 4: eine Schnittansicht eines erfindungsgemässen Abgaskrümmers mit thermoelektrischen Elementen,
- Fig. 5: eine Schnittansicht eines erfindungsgemässen Abgaskrümmers mit thermoelektrischen Elementen mit einem Füllelement
- Fig. 6: eine dreidimensionale Darstellung eines erfindungsgemässen Abgaskrümmers mit thermoelektrischem Elemente an der Frontseite und
- Fig. 7: eine Schnittansicht eines erfindungsgemässen Abgaskrümmers mit thermoelektrischem Element an der Frontseite.

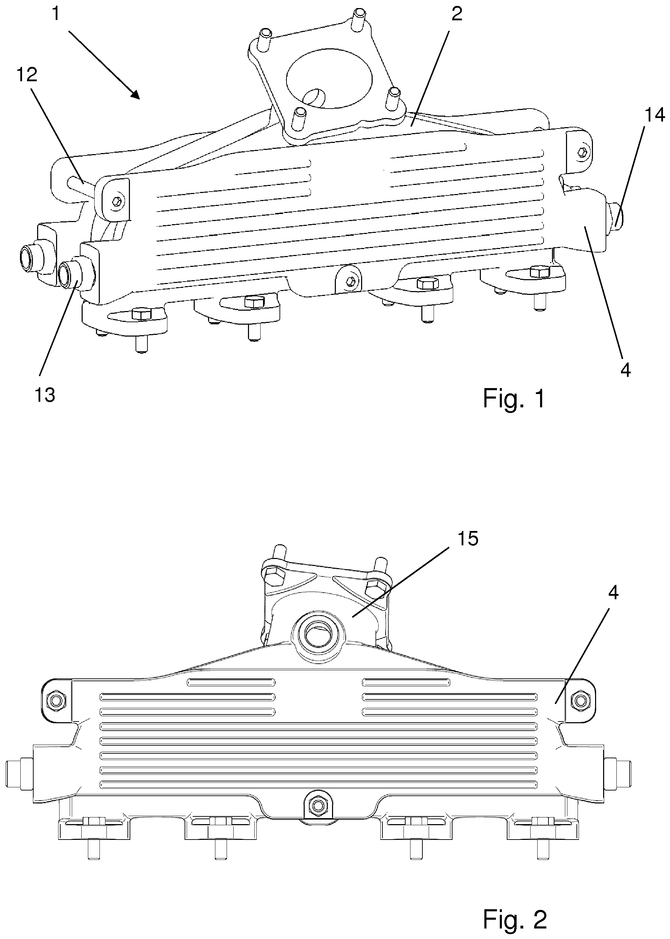

Die in Fig. 1 dargestellte Zeichnung zeigt eine dreidimensionale Ansicht eines erfindungsgemässen Abgaskrümmers mit thermoelektrischen Elementen 1.

Die abgebildete Ausführungsformen zeigen Varianten bei denen auf zwei Seiten also unten und oben des Abgaskrümmers die thermoelektrischen Elemente und die Kühlelemente angebracht sind, jedoch ist selbstverständlich auch eine mögliche Ausführungsform die eines erfindungsgemässen Abgaskrümmers der nur unten oder nur oben die Elemente aufweist, wie auch nur an der Frontseite oder an allen Seiten, das heisst, oben, unten und an der Frontseite.

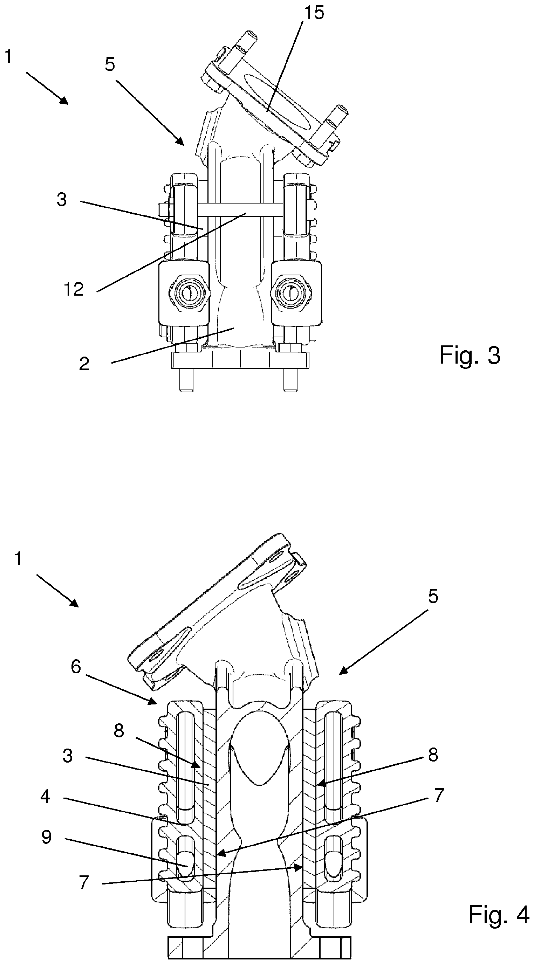

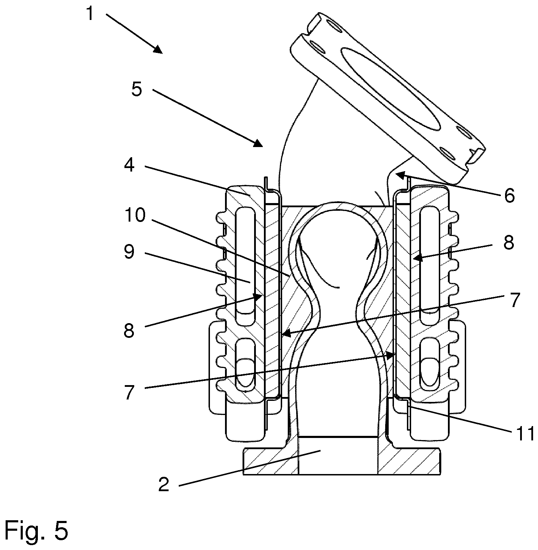

In der dargestellten Ausführungsform in Fig. 1 sind die Kühlelemente 4 mit Hilfe von Befestigungsmitteln 12 am Abgaskrümmer 2 befestigt, wobei in der dargestellten Ausführungsform die Kühlelemente 4, welche jeweils eines an der Abgaskrümmeroberseite 5 und eines an der Abgaskrümmerunterseite 6 angeordnet ist, miteinander verspannt sind. Selbstverständlich sind auch andere Anordnungen und Befestigungselemente zur Befestigung der Kühlelemente 4 am Abgaskrümmer 2 denkbar. Die thermoelektrischen Elemente 3 sind zwischen den Kühlelementen 4 und der Abgaskrümmeroberseite 5 sowie dem andern Kühlelement 4 und der Abgaskrümmerunterseite 6 angeordnet und in Fig. 3 - 5 ersichtlich. Die Kühlelemente 4 weisen in ihrem Innern mindestens einen Kühlkanal 9 auf, in Fig. 4 und 5 dargestellt, der von einem Fluid durchströmt wird und so das Kühlelement 4 gekühlt wird. Vorzugsweise befinden sich die Einlass- und Auslassöffnungen 13, 14 an den Stinseiten der Kühlelemente 4. Die Kühlelemente 4 sind als separate Teile ausgebildet, was gut in den Fig. 4 und 5 zu erkennen ist. Dadurch kann der Abgaskrümmer 2 wie auch die Kühlelemente 4 jeweils aus einem anderen Werkstoff hergestellt sein, der den Anforderungen am besten entspricht. Fig. 2 zeigt den erfindungsgemässen Abgaskrümmer mit thermoelektrischen Elementen 1 in einer Draufsicht, somit ist hier hauptsächlich das Kühlelement 4, welches an der Abgaskrümmeroberseite 5 angeordnet ist sichtbar. Gut erkennbar ist auch, dass sich das Kühlelement 3 über die komplette Breite des Abgaskrümmers 2 erstreckt, das heisst, über alle Abgaseinlässe sowie auch über die Länge des Abgaskrümmers, die etwa der Länge der Abgaseinlässe entspricht bis hin zum Auslassstutzen 15 um somit die vorhandene Fläche optimal auszunutzen und dadurch keine unnötigen Trennstellen einzelner Kühlelemente 3 vorliegen.

Fig. 3 zeigt einen erfindungsgemässen Abgaskrümmer mit thermoelektrischen Elementen 1 in einer Seitenansicht. Deutlich erkennbar sind die thermoelektrischen Elemente 3, welche zwischen der Abgaskrümmeroberseite 5 und einem Kühlelement 4 sowie der Abgaskrümmerunterseite 6 und einem weiteren Kühlelement 4 angeordnet sind. In der in Fig. 3 dargestellten Ausführungsform sind die Kühlelemente 4 mittels eines Befestigungsmittels 12 an den Abgaskrümmer 2 angepresst, jedoch gibt es hierzu unzählige Varianten die Kühlelemente 4 am Abgaskrümmer 2 zu befestigen, wobei noch die thermoelektrischen Elemente 3 dazwischen angeordnet sind bzw. geklemmt sind.

Fig. 4 zeigt einen erfindungsgemässen Abgaskrümmer mit thermoelektrischen Elementen 1 in Schnittansicht. Hierbei ist gut erkennbar, dass die beiden thermoelektrischen Elemente 3 an der Abgaskrümmerober- und unterseite 5, 6 anliegen. An der Seite 8 des thermoelektrischen Elements 3, welche vom Abgaskrümmer abgewandt ist liegt das Kühlelement 4 an. Dadurch, dass das thermoelektrische Element 3 auf der einen Seite 7 am heissen Abgaskrümmer 2 anliegt und die andere Seite 8 am kühlen Kühlelement 4 anliegt wird eine hohe Spannung generiert die als Energie genutzt werden kann. In Fig. 4 und 5 ist der Kühlkanal 9 des Kühlelements 4 ersichtlich, wobei das Kühlelement 4 erfindungsgemäß als einteiliges Gussteil ausgebildet ist aber auch einer Herstellung als Frästeil, welches durch zwei Halbschalen gebildet wird die mittels einer Dichtung zu einem Kühlelement 4 zusammengefügt werden ist denkbar (nicht dargestellt).

Fig. 5 zeigt eine weitere Ausführungsform eines Abgaskrümmers mit thermoelektrischen Elementen 1 wobei das thermoelektrische Element 3 mittels eines Befestigungsmittels 11 am Kühlelement 4 befestigt ist, so dass eine vormontierbare Montagegruppe gebildet wird, die einfach am Abgaskrümmer 2 befestigt werden kann.

Des Weiteren zeigt Fig. 5 auch die Möglichkeit eines Füllelements 10, welches das Anliegen des thermoelektrischen Elements 3 am Abgaskrümmer 2 optimiert bzw. eine Auflage bildet. Das Füllelement 10 weist vorzugsweise einen sehr leitfähigen Werkstoff auf, damit die Wärme des Abgaskrümmers 2 gut an die Seite 7 des thermoelektrischen Elements 3 geleitet werden kann und eine hohe Temperaturdifferenz zwischen der dem Abgaskrümmer zugewandten Seite 7 und der dem Kühlelement zugewandten Seite 8 vorliegt. Selbstverständlich kann ein Füllelement 10 auch eingesetzt werden wenn keine Befestigungsmittel 11 zur Vormontage einer Montagebaugruppe vorliegen wie auch eine solche vormontierte Baugruppe auch ohne Füllelement 10 am Abgaskrümmer 2 angeordnet sein kann.

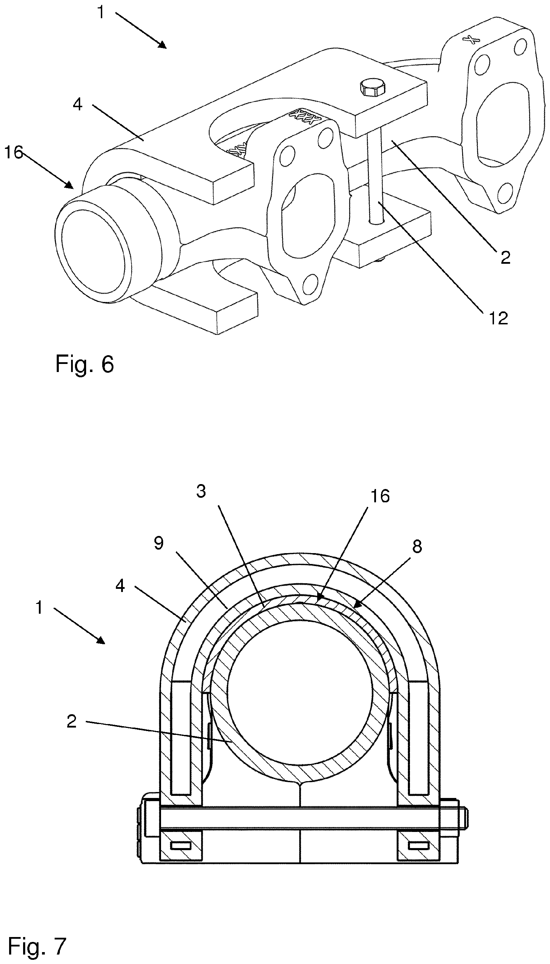

In Fig. 6 und 7 ist eine weitere Ausführungsform des erfindungsgemässen Abgaskrümmers 1 abgebildet. Darin ist gut erkennbar, dass ein thermoelektrisches Element 3 an der Abgaskrümmerseite 16, bzw. an der Frontseite 16 des Abgaskrümmers anliegt und ein Kühlelement 4 an der von der Abgaskrümmer abgewandten Seite 8 des thermoelektrischen Elements 3 anliegt. Selbstverständlich ist auch eine Kombination der thermoelektrischen Elemente 3 und der Kühlelemente 4 der verschiedenen Ausführungsformen denkbar.

### Bezugszeichenliste

- 1: Abgaskrümmer mit thermoelektrischem Element
- 2: Abgaskrümmer
- 3: Thermoelektrisches Element
- 4: Kühlelement
- 5: Abgaskrümmerseite (oben)
- 6: Abgaskrümmerseite (unten)
- 7: Seite thermoelektrisches Element dem Abgaskrümmer zugewandt / anliegend
- 8: Seite thermoelektrisches Element dem Abgaskrümmer abgewandt / am Kühlelement anliegend
- 9: Kühlkanal
- 10: Füllelement
- 11: Befestigungsmittel
- 12: Befestigungselement
- 13: Einlass Kühlkanal
- 14: Auslass Kühlkanal
- 15: Auslassstutzen
- 16: Abgaskrümmerseite (Frontseite)

## Patentansprüche

1. Abgaskrümmer mit thermoelektrischem Element (1) zur Nutzung der Abwärme des Verbrennungsmotors beinhaltend einen Abgaskrümmer (2) vorzugsweise aus Gussmaterial, mindestens ein thermoelektrisches Element (3), wobei das thermoelektrische Element (3) vorzugsweise als Platte ausgebildet ist und das thermoelektrische Element (3) durch die auftretende Temperaturdifferenz zwischen der einen Seite (7, 8) und der gegenüberliegenden Seite (7, 8) eine elektrische Spannung erzeugt, wobei mindestens ein thermoelektrisches Element (3) an mindestens einer Abgaskrümmerseite (5, 6, 16) angeordnet ist, wobei am thermoelektrischen Element (3) an der vom Abgaskrümmer abgewandten Seite (8) ein Kühlelement angeordnet ist, wobei das Kühlelement mindestens einen Kühlkanal (9) aufweist, wobei der Kühlkanal (9) zur Durchströmung eines Fluids dient, **dadurch gekennzeichnet, dass** der Abgaskrümmer (2) und das Kühlelement (4) als separate Teile ausgebildet sind, wobei das Kühlelement (4) ein Gussteil ist.

2. Abgaskrümmer (1) nach Anspruch 1, **dadurch gekennzeichnet, dass** sich das Kühlelement (4) über die komplette Breite der Abgaskrümmerseite (5, 6, 16) erstreckt.

3. Abgaskrümmer (1) nach einem der Ansprüche 1 oder 2, **dadurch gekennzeichnet, dass** das Kühlelement (4) an einer Seite direkt am thermoelektrischen Element (3) anliegt um eine direkte Kühlung zu erreichen.

4. Abgaskrümmer (1) nach einem der Ansprüche 1 bis 3, **dadurch gekennzeichnet, dass** das thermoelektrisches Element (3) direkt an der Abgaskrümmerseite (5, 6, 16) anliegt bzw. an dessen äusserer Oberfläche, vorzugsweise ist ausschliesslich ein thermoelektrisches Element (3) an der Abgaskrümmerseite (5, 6, 16) angeordnet, wobei das thermoelektrische Element (3) vorzugsweise als ein durchgehendes Teil ausgebildet ist.

5. Abgaskrümmer (1) nach einem der Ansprüche 1 bis 3, **dadurch gekennzeichnet, dass** das zwischen der äusseren Oberfläche der Abgaskrümmerseite (5, 6, 16) und dem thermoelektrischen Element (3) ein Füllelement (10) angeordnet ist.

6. Abgaskrümmer (1) nach einem der Ansprüche 1 bis 5, **dadurch gekennzeichnet, dass** jeweils an der Abgaskrümmeroberseite (5) und an der Abgaskrümmerunterseite (6) ein thermoelektrisches Element (3) angeordnet ist.

7. Abgaskrümmer (1) nach einem der Ansprüche 1 bis 6, **dadurch gekennzeichnet, dass** an der Abgaskrümmerfrontseite (16) ein thermoelektrisches Element (3) angeordnet ist.

8. Abgaskrümmer (1) nach einem der Ansprüche 1 bis 7, **dadurch gekennzeichnet, dass** das thermoelektrische Element (3) am Kühlelement (4) befestigt ist, vorzugsweise mittels eines Befestigungsmittels (11).

## Claims

1. Exhaust gas manifold with a thermo-electric element (1) for utilizing the waste heat of the internal combustion engine comprising an exhaust gas manifold (2) which is preferably made from cast material, at least one thermo-electric element (3), the thermo-electric element (3) preferably being configured as a plate, and the thermo-electric element (3) generating an electric voltage by way of the temperature difference which occurs between the one side (7, 8) and the opposite side (7, 8), at least one thermo-electric element (3) being arranged on at least one exhaust gas manifold side (5, 6, 16), a cooling element being arranged on the thermo-electric element (3) on the side (8) which faces away from the exhaust gas manifold, the cooling element having at least one cooling duct (9), the cooling duct (9) serving for the throughflow of a fluid, **characterized in that** the exhaust gas manifold (2) and the cooling element (4) are configured as separate parts, the cooling element (4) being a cast part.

2. Exhaust gas manifold (1) according to Claim 1, **characterized in that** the cooling element (4) extends over the complete width of the exhaust gas manifold side (5, 6, 16).

3. Exhaust gas manifold (1) according to either of Claims 1 and 2, **characterized in that** the cooling element (4) bears on one side directly against the thermo-electric element (3), in order to achieve direct cooling.

4. Exhaust gas manifold (1) according to one of Claims 1 to 3, **characterized in that** the thermo-electric element (3) bears directly against the exhaust gas manifold side (5, 6, 16) or against its outer surface, and preferably exclusively a thermo-electric element (3) is arranged on the exhaust gas manifold side (5, 6, 16), the thermo-electric element (3) preferably being configured as a continuous part.

5. Exhaust gas manifold (1) according to one of Claims 1 to 3, **characterized in that** a filling element (10) is arranged between the outer surface of the exhaust gas manifold side (5, 6, 16) and the thermo-electric element (3) .

6. Exhaust gas manifold (1) according to one of Claims 1 to 5, **characterized in that** a thermo-electric element (3) is arranged in each case on the exhaust gas manifold upper side (5) and on the exhaust gas manifold lower side (6) .

7. Exhaust gas manifold (1) according to one of Claims 1 to 6, **characterized in that** a thermo-electric element (3) is arranged on the exhaust gas manifold front side (16) .

8. Exhaust gas manifold (1) according to one of Claims 1 to 7, **characterized in that** the thermo-electric element (3) is fastened to the cooling element (4), preferably by means of a fastening means (11).

## Revendications

1. Collecteur de gaz d'échappement avec élément thermoélectrique (1) permettant d'exploiter la chaleur perdue du moteur à combustion interne, comprenant un collecteur de gaz d'échappement (2) de préférence en fonte, au moins un élément thermoélectrique (3), l'élément thermoélectrique (3) étant de préférence réalisé sous forme de plaque et l'élément thermoélectrique (3) générant une tension électrique par la différence de température qui se produit entre une face (7, 8) et la face opposée (7, 8), dans lequel au moins un élément thermoélectrique (3) est disposé sur au moins une face de collecteur de gaz d'échappement (5, 6, 16), un élément de refroidissement étant disposé sur l'élément thermoélectrique (3) sur la face détournée du collecteur de gaz d'échappement (8), dans lequel l'élément de refroidissement présente au moins un conduit de refroidissement (9), le conduit de refroidissement (9) servant au passage d'un fluide, **caractérisé en ce que** le collecteur de gaz d'échappement (2) et l'élément de refroidissement (4) sont réalisés comme des pièces séparées, l'élément de refroidissement (4) étant une pièce en fonte.

2. Collecteur de gaz d'échappement (1) selon la revendication 1, **caractérisé en ce que** l'élément de refroidissement (4) s'étend sur toute la largeur de la face de collecteur de gaz d'échappement (5, 6, 16).

3. Collecteur de gaz d'échappement (1) selon l'une quelconque des revendications 1 ou 2, **caractérisé en ce que** l'élément de refroidissement (4) est sur une face directement adjacente à l'élément thermoélectrique (3) pour obtenir un refroidissement direct.

4. Collecteur de gaz d'échappement (1) selon l'une quelconque des revendications 1 à 3, **caractérisé en ce que** l'élément thermoélectrique (3) est directement adjacent à la face de collecteur de gaz d'échappement (5, 6, 16) ou à la surface extérieure de celui-ci, de préférence un seul élément thermoélectrique (3) est disposé sur la face de collecteur de gaz d'échappement (5, 6, 16), l'élément thermoélectrique (3) étant de préférence réalisé comme une pièce d'un seul tenant.

5. Collecteur de gaz d'échappement (1) selon l'une quelconque des revendications 1 à 3, **caractérisé en ce qu'**un élément de remplissage (10) est disposé entre la surface extérieure de la face de collecteur de gaz d'échappement (5, 6, 16) et l'élément thermoélectrique (3) .

6. Collecteur de gaz d'échappement (1) selon l'une quelconque des revendications 1 à 5, **caractérisé en ce qu'**un élément thermoélectrique (3) est disposé respectivement sur la face supérieure de collecteur de gaz d'échappement (5) et sur la face inférieure de collecteur de gaz d'échappement (6).

7. Collecteur de gaz d'échappement (1) selon l'une quelconque des revendications 1 à 6, **caractérisé en ce qu'**un élément thermoélectrique (3) est disposé sur la face avant de collecteur de gaz d'échappement (16).

8. Collecteur de gaz d'échappement (1) selon l'une quelconque des revendications 1 à 7, **caractérisé en ce que** l'élément thermoélectrique (3) est fixé à l'élément de refroidissement (4), de préférence à l'aide d'un moyen de fixation (11).
